# EUROPEAN PATENT SPECIFICATION

(11) **EP 1 728 894 B1**
(45) Date of publication and mention of the grant of the patent: **15.10.2008**
(21) Application number: 06114855.7
(22) Date of filing: 01.06.2006
(51) Int. Cl.: C23C 16/455, C23C 16/40

(54) **Atomic layer deposition (ald) method for producing a high quality layer**
Beschichtungsverfahren mit atomaren Schichten (ald) zum Erzeugen einer Schicht hoher Qualität
Procédé de dépot de couches atomiques (ALD ) pour produire une couche de haute qualité

(30) Priority: 01.06.2005 US 686811 P; 25.11.2005 EP 05447261
(43) Date of publication of application: 06.12.2006
(73) Proprietor: INTERUNIVERSITAIR MICROELEKTRONICA CENTRUM ( IMEC), 3001 Leuven (BE)
(72) Inventor: DELABIE, Annelise, 3360, BIERBEEK (BE); CAYMAX, Matty, 3001, LEUVEN (BE)
(74) Representative: pronovem

(56) References cited:
- WO-A-20/04086481
- US-A1- 2003 175 423
- US-A1- 2004 182 417
- US-A1- 2004 187 784
- US-A1- 2004 247 787
- US-A1- 2005 011 457

## Description

### Field of invention

The present invention is related to an improved method for Atomic Layer deposition. Further, it is also related to a reactor design suitable for applying the method.

### Background

Because in the field of electronics in general further downscaling of the semiconductor devices is always proceeding, deposition processes have to be developed able to deposit layers with a thickness control at atomic layer scale.

One of these deposition techniques is Atomic Layer Deposition (ALD), often used for depositing dielectric layers.

Atomic Layer Deposition is a thin film deposition technique based on the use of separated chemisorption reactions of at least two gas phase reactants with a substrate.

There are two characteristics which can limit the quality and scalability of layers deposited by ALD. A first characteristic is the growth-per-cycle (GPC), which often is much lower than the theoretical maximum of one monolayer per cycle. This can result in film roughness and slow film closure, which makes especially thin films (thinner than about 5 nm) prone to localized defects such as pinholes.

A second characteristic is the presence of impurities due to unreacted precursor ligands.
For example, in the deposition of hafnium oxide from hafnium tetrachloride and water, the growth-per-cycle is only 20% of a monolayer and the C1-impurities remain in the deposited layer.

EP 1 608 006 describes a deposition system which supplies a source gas and a purge gas alternately for deposition, comprising:
a deposition chamber; a substrate holding unit which holds a substrate in the deposition chamber; a source gas supply unit which supplies the source gas to the deposition chamber; a reactive gas supply unit which supplies a reactive gas to the deposition chamber;
a purge gas supply unit which supplies the purge gas to the deposition chamber; an exhaust unit which exhausts the source gas, the reactive gas, and the purge gas from the deposition chamber; a first heating unit which heats the substrate arranged in the deposition chamber to maintain the same to a predetermined temperature; and a second heating unit which heats the substrate arranged in the deposition chamber rapidly.

US 2003/175423 describes an ALD method wherein the process sequence includes rapid temperature changes on a substrate surface of a substrate arranged in the ALD process chamber.

US 2005/011457 describes an ALD method wherein the adsorption reaction of the first precursor occurs at a different temperature state than the temperature state required for the reaction with the second precursor.

### Aim of the invention

The present Invention aims to provide an ALP method and reactor to fabricate a high-quality ALD layer under optimized process conditions.

### Summary of the invention

The present invention provides an ALD method comprising the steps of:
a) providing a semiconductor substrate in a reactor
b) providing a pulse of a first precursor gas into the reactor at a first reactor temperature,
c) providing a first pulse of a second precursor gas into the reactor at a second temperature,
d) providing a second pulse of the second precursor gas at a third temperature lower than the second temperature, and
e) optionally, repeating at least once step b) through step d) till a desired layer thickness is achieved.

The first precursor gas can be a halide or an oxyhalide such as POCl₃, and more particularly it can be a metal halide or a metal oxyhalide such as HfCl₄, TaCl₅, WF₆, WOCl₄, ZrCl₄, AlCl₃, TiCl₄, SiCl₄ or the like.

The second precursor gas can be any precursor able to decompose the first precursor, or to eliminate the ligands of the first precursor. More particularly it can be H₂O, H₂O₂, O₂, O₃, NH₃, H₂S, H₂Se, PH₃, AsH₃, C₂H₄ or Si₂H₆.

In a method according to the invention said first temperature can be between about 100°C and about 800°C, preferably between about 150°C and about 650°C, or between about 200°C and about 500°C, or more preferably between about 225°C and about 375°C.

In a method according to the invention said second temperature can be substantially equal or higher than the first temperature, more particularly between about 100°C and about 800°C, preferably between about 150°C and about 650°C, or between about 200°C and about 500°C, or more preferably between about 225°C and about 375°C.

In a method according to the invention said third temperature can be substantially lower than the second temperature, preferably lower than about 500°C, or than about 350°C, or than about 225°C and more preferably is room temperature.

A method according to the invention can further comprise the step of heating the substrate surface at a fourth temperature, between step c) and d).

In a method according to the invention said fourth temperature can be substantially equal or higher than the second temperature, preferably higher than about 375°C and more preferably equal to about 500°C.

In a method according to the invention, the step of heating the substrate surface at a fourth temperature can be performed in inert atmosphere.

In a method according to the invention, the substrate can be exposed to a plasma treatment during and/or after step d).

The plasma used for said plasma treatment can consist of N₂O, NO, O₂, N₂, H₂, NO₂, or NH₃, etc.

In a preferred method according to the invention the first and second temperature is about 300°C, the third temperature is room temperature and the fourth temperature (if any) is about 500°C.

An ALD reactor suitable for carrying out a method according to the invention is the following:

The ALD reactor comprises:
i. a first and a second susceptor,
ii. means for heating a substrate when present on the first susceptor, and
iii. means for cooling the substrate when present on the second susceptor.

The reactor can further comprise means for transporting a semiconductor substrate between both susceptors.

The reactor can further comprise means for producing a plasma.

### Short description of the drawings

Figure 1: Effect of the H₂O pulse length on the GPC as determined by RBS (Rutherford Backscattering Spectroscopy).

Figure 2: Effect of the H₂O pulse length on the TOFSIMS (Time-Of-Flight Secondary Ion Mass Spectroscopy) Cl-profile.

Figure 3: Growth-per-cycle (RBS) as a function of the number of cycles for HfO₂ on 1 nm chemical oxide substrates.

Figure 4: Decay of the TOFSIMS Si intensity as a function of the RBS Hf-coverage for HfO₂ deposited with IRPA and standard ALD on chemical oxide substrates, and for standard HfO₂ on different starting substrates.

Figure 5: TOFSIMS Cl-profiles of HfO₂ deposited with different extended reaction cycles (a) and after different post deposition anneals (b).

Figure 6: TOFSIMS Cl-profiles of HfO₂ deposited with intermediate cooling and longer H₂O pulses.

Figure 7: Moisture background in the transport module of the polygon as monitored by a FabSense H₂O sensor (BOC Edwards).

Figure 8: TDS spectrum of ALD HfO₂.

### Description of the invention

Atomic Layer Deposition (ALD) is a thin film deposition technique based on the use of separated chemisorption reactions of at least two gas phase reactants with a substrate. Such gas phase reactants are also called precursor gasses.

There are two characteristics which can limit the quality and scalability of layers deposited by ALD.

A first characteristic is the growth-per-cycle (or growth rate), which is often much lower than the theoretical maximum of one monolayer per cycle. This can result in film roughness and slow film closure, which makes especially thin films (on the order of less than 5 nm) prone to localized defects such as pinholes.

A second characteristic is the presence of impurities due to unreacted precursor ligands.

In order to optimize the above characteristics, the present invention provides an ALD method comprising the steps of:
a) providing a semiconductor substrate in a reactor,
b) providing a pulse of a first precursor gas into the reactor at a first temperature,
c) providing a first pulse of a second precursor gas into the reactor at a second temperature,
d) providing a second pulse of the second precursor gas at a third temperature lower than the second temperature, and
e) optionally repeating at least once step b) through step d) till a desired layer thickness is achieved.

The semiconductor substrate can comprise or can consist of any semiconductor material(s) suitable in the field of IC processing. In particular it can comprise or can consist of silicon, germanium or silicon germanium.

The layer obtainable by a method according to the invention can be of a substantially pure element (e.g. Si, Cu, Ta, W), an oxide (e.g. SiO₂, GeO₂, HfO₂, ZrO₂, Ta₂O₅, TiO₂, Al₂O₃, POₓ, VOₓ, CrOₓ, FeOₓ, ZnO, SnO₂, Sb₂O₅, B₂O₃, In₂O₃, WO₃), a nitride (e.g. Si₃N₄, TiN, TaNₓ, AlN, BN, GaN, NbN, MoₓN, WₓN), a carbide (e.g. SiC), a sulfide (e.g. CdS, ZnS, MnS, WS₂, PbS), a selenide (e.g. CdSe, ZnSe), a phosphide (e.g. GaP, InP), an arsenide (e.g. GaAs, InAs), or mixtures thereof.

The first precursor gas can be a halide or an oxyhalide such as POCl₃. More particularly it can be a metal halide or a metal oxyhalide. For example, said first precursor can be HfCl₄, TaClₛ, WF₆, WOCl₄, ZrCl₄, AlCl₃, , TiCl₄, SiCl₄ or the like.

The second precursor gas can be any precursor able to eliminate the ligands of the first precursor. More particularly it can be H₂O, H₂O₂, O₂, O₃, NH₃, H₂S, H₂Se, PH₃, AsH₃, C₂H₄ or Si₂H₆.

In the context of the invention the first, second and third temperature is to be understood as the temperature in the reactor, unless otherwise stated.

In a method according to the invention the first temperature can be between (about) 100°C and (about) 800°C, preferably between (about) 150°C and (about) 650°C, or between (about) 200°C and (about) 500°C, and more preferably between (about) 225°C and (about) 375°C.

In a method according to the invention the second temperature can be substantially equal or higher than the first temperature, between (about) 100°C and (about) 800°C, preferably between (about) 150°C and (about) 650°C, or between (about) 200°C and (about) 500°C, and more preferably between (about) 225°C and (about) 375°C.

In a method according to the invention the third temperature can be substantially lower than the second temperature, preferably lower than (about) 500°C, or lower than (about) 350°C, or lower than (about) 225°C and more preferably is room temperature.

A method according to the invention can further comprise the step of heating the substrate surface at a fourth temperature, between step c) and d).

In a method according to the invention this fourth temperature can be substantially equal or higher than the second temperature, higher than (about) 375°C and preferably equal to (about) 500°C.

Said step of heating the substrate surface at a fourth temperature can be performed in inert atmosphere, such as but not limited to nitrogen or argon.

In a method according to the invention, the substrate can be exposed to a plasma treatment during and/or after step d). The plasma can be direct or remote.

Said plasma can consist of N₂O, NO, O₂, N₂, H₂, NO₂, or NH₃, etc.

In a preferred method according to the invention the first and second temperature is (about) 300°C, the third temperature is room temperature and the fourth temperature is (about) 500°C.

A reactor design that is suitable for performing the method of the invention and in which reactions can be performed at their optimized temperature is the following ALD reactor.

Such an ALD reactor comprises:
- a first and a second susceptor,
- means for heating a substrate when present on the first susceptor, and
- means for cooling the substrate when present on the second susceptor.

In the framework of the invention, a susceptor is any means, e.g. a plate, suitable for supporting (bearing) the substrate upon which the layer is to be deposited.

The ALD reactor can further comprise means for transporting a semiconductor substrate between both susceptors.

The ALD reactor can further comprise means for producing a plasma.

The means for heating can comprise flash lamps or any means to create a temperature increase of at least the substrate surface.

The means for cooling can comprise a recirculating cooling medium, such as cooled nitrogen, or a Peltier element or any means to create a temperature decrease of at least the substrate surface.

In a particular embodiment according to the present invention, a hafnium oxide layer can be deposited using a method of the invention wherein hafnium tetrachloride is the first precursor gas and water the second precursor gas.

More particularly, an ALD method for depositing an hafnium oxide layer can comprise the steps of:
**i.** providing a semiconductor substrate in the ALD reactor,
**ii.** providing a pulse of HfCl₄ in the reactor at 300°C,
**iii.** providing a first pulse of H₂O in the reactor at 300°C,
**iv.** optionally heating the substrate at 500°C in N₂ atmosphere,
**v.** providing a second pulse of H₂O in the reactor at room temperature, while the substrate can be exposed to an N₂O plasma treatment, and
**vi.** optionally, repeating at least once step ii) through step v).

The reaction cycle (step (ii) through step (v)) can then be repeated until the desired layer thickness is obtained.

The step of providing the second pulse of H₂O can also comprise exposure to moisture present in the reactor.

The steps of providing a pulse of HfCl₄, providing a first pulse of H₂O and heating the substrate can be performed on the first susceptor. The temperature is maintained constant at (about) 300°C. Heating means, e.g. (flash) lamps, are provided for fast wafer surface temperature increase from (about) 300°C to (about) 500°C when the substrate is present on the first susceptor.

Then the substrate is transported from the first to the second susceptor.

The second H₂O pulse (which can comprise moisture exposure during transportation in this case) and optionally plasma exposure can be performed on the second susceptor at lower temperature. Cooling means are provided for wafer surface temperature decrease below (about) 225°C or even to room temperature.

By means of conventional ALD, the deposition of hafnium oxide from hafnium tetrachloride and water, the growth-per-cycle is only 20% of a monolayer and the Cl-impurities remain in the deposited layer.

By means of the method according to the invention, the growth-per-cycle can be enhanced from 15% to 40% of a monolayer and the Cl-content can be reduced by 2 orders of magnitude.

Though the following example describes only the deposition of HfO₂ from HfCl₄ and H₂O, it is to be understood that said first and second precursors as defined in the present invention are expected to follow the same chemical mechanisms as described in the example section, when carrying out a method of the invention. Therefore, the present invention is not intended to be limited to the following illustrative example.

### Example

Atomic Layer Deposition (ALD) is based on the use of separated chemisorption reactions of at least two gas phase reactants with a substrate.

For the deposition of HfO₂ from HfCl₄ and H₂O, HfCl₄, which is the first precursor, chemisorbs on the substrate by reaction with surface -OH groups:
x OH* + HfCl₄ → OₓHfCl₄₋ₓ* + x HCl

The chemisorption must be self-limiting and saturated within the time of the precursor pulse. When full saturation is reached, the excess of HfCl₄ and the gas reaction byproducts are purged away by a nitrogen flow, further referred to as a nitrogen purge. Thereafter, pulse and nitrogen purge steps are repeated with the H₂O precursor in order to hydrolyze the Hf-Cl bonds.
OₓHfCl₄₋ₓ* + (4-x) H₂O → OₓHf(OH)₄₋ₓ + (4-x) HCl

This sequence is repeated until the desired HfO₂ film thickness is obtained.

Usually, the growth-per-cycle is less than 1 monolayer because of the following limitations: either the number of reactive sites on the substrate is limited, or steric effects from bulky precursors limit the amount of material to be chemisorbed.

Moreover, the growth-per-cycle can depend on the starting substrate - when the substrate changes from the starting substrate (for example silicon substrate) to the deposited material itself. When starting substrate effects have vanished, the growth-per-cycle becomes constant and is referred to as the steady growth-per-cycle.

Furthermore, the growth-per-cycle can depend on the temperature of the deposition.

For the conventional HfCl₄/H₂O process (also referred to as Standard HfCl₄/H₂O ALD process), the steady growth-per-cycle at 300°C is only 15% - 17 % of a monolayer (also referred to as %ML). Several experimental observations indicate that the low HfO₂ growth-per-cycle is caused by limitation of the number of reactive sites, the -OH groups in the HfCl₄ reaction.

For example, the decreasing growth-per-cycle as a function of temperature is attributed to decreased hydroxylation of the HfO₂ surface. This implies that the HfCl₄ reaction with oxygen bridging sites is not very efficient. Indeed, it has been shown that the ZrCl₄ species (the HfCl₄ and ZrCl₄ chemistries are very similar) are not very reactive towards siloxane bridges, since the preheating temperature of the support influences the amount of adsorbed Zr.

Furthermore, substrate inhibition occurs typically on surfaces with too low -OH density, for example HF cleaned Si.

As an illustration of several embodiments of the present invention, an ALD reaction cycle with different intermediate treatments, such as exposure to gas phase moisture, plasma treatments or thermal anneals is studied and compared to the Standard ALD cycle.

In the case of an ALD cycle with plasma treatments, which is a particular embodiment of the present invention, this extended ALD process is also referred to as Intermediate Remote Plasma Assisted (IRPA) ALD.

In the case of an ALD cycle with a thermal anneal, which is also a particular embodiment of the present invention, this extended ALD process is also referred to as Intermediate Thermal Anneal (ITA) ALD.

A first goal is to increase the number of -OH groups at the HfO₂ surface, in order to enhance the growth-per-cycle. A theoretical model predicts that the higher the growth-per-cycle, the lower the number of cycles required for film closure and the lower the roughness of the film. Therefore, the improvement of the quality and scalability of HfO₂ layers by enhancing the growth-per-cycle with intermediate treatments is investigated.

A second goal is to reduce the Cl-content of the Hf02 layers. Indeed, the intermediate treatments can affect the growth-per-cycle and the Cl-content.

All samples are processed in a Polygon 8200 cluster. Prior to deposition, a chemical oxide of 1 nm thickness is grown. HfO₂ is deposited in an ALCVD^{™} Pulsar^{®} 2000 reactor, a hot wall cross-flow type reactor with inert gas valving. The pressure in the reactor is 1.33 mbar (1 Torr). All pulses with HfCl₄ precursor and first pulses with H₂O precursor are performed at 300°C. HfCl₄ is a solid at room temperature. It is heated to approximately 185°C to achieve sufficient vapor pressure for the HfCl₄ pulses. The pulse and inert gas purge times for the Standard process are indicated in Table 1. Elongation of the purge times after HfCl₄ or H₂O pulses up to 5 minutes does not change the growth-per-cycle, suggesting that the precursor pulses are well separated in the standard conditions. Moreover, this indicates that there is sufficient recovery time of the HfCl₄ solid source between different pulses.

**Table 1: Pulse and inert gas purge parameters in the standard HfO₂ deposition.**

| | |
|---|---|
| HfCl₄ pulse (s) | 0.1 |
| N₂ purge (s) | 1 |
| H₂O pulse (s) | 0.3 |
| N₂ purge (s) | 3 |

Samples are measured by spectroscopic ellipsometry (SE) on a KLA-Tencor ASET F5. RBS is performed in a RBS400 end station (Charles Evans and Associates) with a 1 MeV He+ beam. TOFSIMS depth profiles are measured with an IonTOF-IV instrument using a dual beam set-up with a 500 eV Ar+ ion beam.

Intermediate treatments are performed in an Epsilon Nitride CVD (Chemical Vapor Deposition) reactor, equipped with a remote Microwave Radical Generator (MRG) or in the transport module of the polygon cluster.

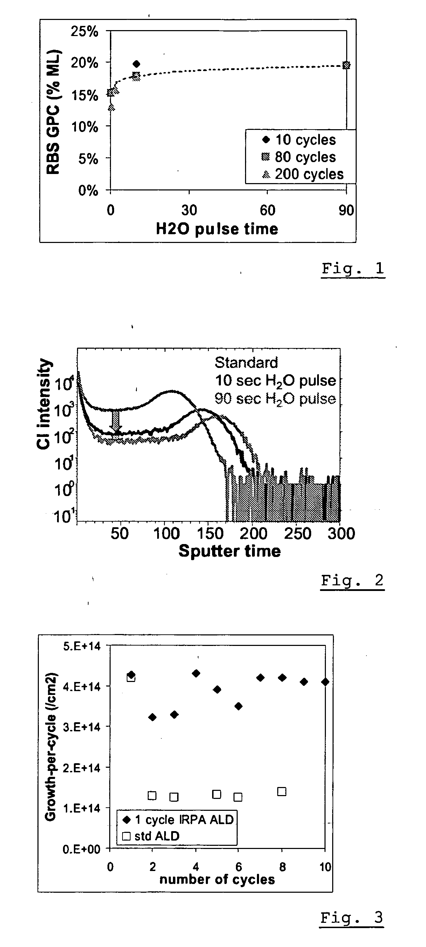

The steady growth-per-cycle for the Standard HfCl₄/H₂O ALD process at 300°C (as described in Table 2) is 1.4 Hf/nm2 or 15% of a monolayer (figure 1), in agreement with literature. The growth-per-cycle is not fully saturated with the standard H₂O pulse of 0.3 seconds, as shown in figure 1. The growth-per-cycle saturates at a H₂O pulse of about 10 seconds to a value of 20% of a monolayer. Also the Cl-content is saturated at 10 seconds, as shown by TOFSIMS (figure 2). The growth-per-cycle does not depend on the HfCl₄ pulse length.

The effect of the 1 nm chemical oxide substrate on the growth-per-cycle for Standard HfCl₄/H₂O ALD compared to IRPA ALD is shown in figure 3. In the first reaction cycle, the growth-per-cycle is almost 3 times higher than the steady growth-per-cycle (4.3 Hf/nm2 or 47% of a monolayer) in agreement with literature. The substrate enhancement only acts in the first reaction cycle. This is surprising, as the chemical oxide substrate can by no means be fully covered by HfO₂ in the first cycle, as less than half a ML is deposited. Therefore, one would expect to see growth enhancement also in the second reaction cycle.

One possible explanation is that all Si-OH groups on the chemical oxide are consumed by reaction with HfCl₄ in the first reaction cycle. Any Si-O-Si bridges left uncovered by HfO₂ are not hydrolyzed in the H₂O pulse of the first reaction cycle. Therefore, HfO₂ in the second reaction cycle only reacts with the Hf-OH groups and the steady Hf02 growth-per-cycle is immediately reached. This would imply that, as the Si-O-Si sites are not reactive towards both HfCl₄ and H₂O precursors, no further growth is possible from the substrate; only sideward growth from HfO₂ islands is possible to cover that area.

Another possibility is that both Si-OH and Si-O-Si bridges react with HfCl₄. The reaction with the latter surface sites results in contamination of the Si substrate by Cl:
Si-O-Si* + HfCl₄ → Si-O-HfCl₃* + Si-Cl

Si-Cl bonds are difficult to hydrolyze at 300°C. Therefore, in the next reaction cycles HfO₂ deposition on the Si-Cl sites is blocked. This would explain the larger Cl-content at the bottom interface of HfO₂ layers. The fact that the HfO₂ growth-per-cycle remains constant in the subsequent reaction cycles, and the decrease in Cl-content could indicate that nucleation on the HfO₂ substrate proceeds only on the Hf-OH groups, and that Hf-O-Hf bridges are less reactive than Si-O-Si bridges.

Plasma treatment every cycle enhances the steady growth-per-cycle from 15% of a monolayer to 42% of a monolayer (figure 3 and table 2).

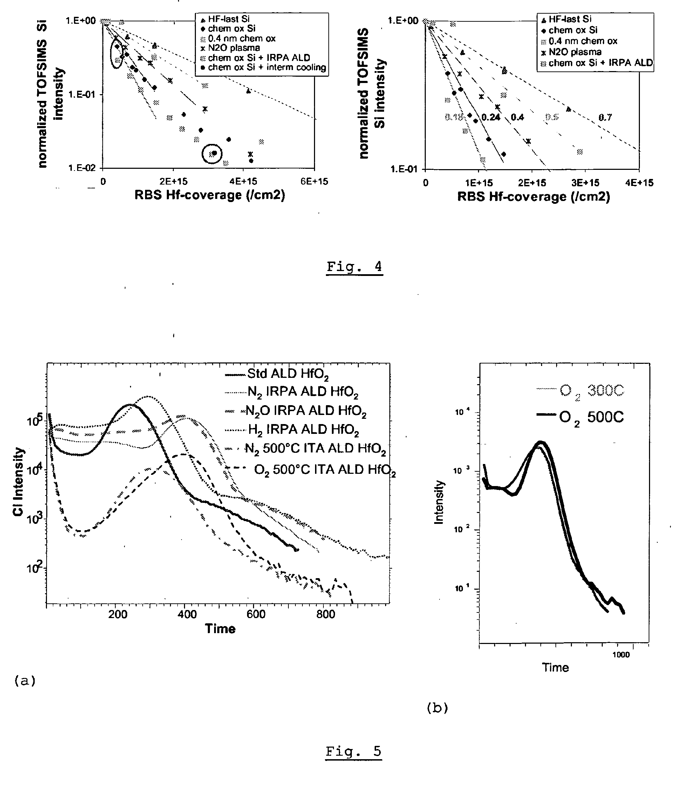

A theoretical model for random deposition in ALD predicts that the higher the growth-per-cycle, the smaller the number of cycles required for film closure and the lower the roughness of the film. The growth mode of HfO₂ layers with different growth-per-cycle can be investigated by TOFSIMS surface measurements. The decay of the Si substrate intensity is plotted as a function of the Hf-coverage from RBS (figure 4).

Indeed, a faster decay of the TOFSIMS Si intensity for IRPA ALD HfO₂ as compared to Standard ALD HfO₂ (figure 4). The difference with Standard HfO₂ ALD is small but systematic.

In table 2 the GPC (% ML) for different extended reaction cycles is shown. The Hf-coverage is measured by RBS or SE on samples with 10 reaction cycles. The growth-per-cycle is calculated as the average over the last 9 reaction cycles to exclude the enhancement effect of the substrate in the first reaction cycle.

**Table 2: Growth-per-cycle for different reaction cycles.**

| | **Description of the reaction cycle** | **GPC RBS (Hf/nm²)** | **GPC RBS (% ML)** | **GPC SE (% ML)** |
|---|---|---|---|---|
| 1 | Standard | 1.40-1.50 | 15 - 16 % | 18 - 20 % |
| 2 | Standard + RT plasma treatment | 4.10 | 42 % | 49 % |
| 3 | Standard + 5 min cooling | 3.21 | 34 % | 40 % |
| 4 | Standard + 90 sec cooling | 2.89 | 32 % | 35 % |
| 5 | Standard + 2 min 420°C + 2 min cooling | 2.95 | 32 % | 35 % |
| 6 | HfCl₄ pulse + 4 min cooling | 0.85 | 9 % | 12 % |
| 7 | HfCl₄ pulse + 2 min 420°C + 4 min cooling | 0.88 | 10 % | 11 % |

Growth enhancement is also observed for room temperature treatments without plasma (table 2 reaction cycle 3 and 4). The growth-per-cycle (34% of a monolayer) is slightly lower as compared to the RT (room temperature) remote plasma treatments (table 2 reaction cycle 2) (42% of a monolayer). Thus, an important contribution of the growth enhancement during plasma treatments comes from lowering the temperature. Therefore, one could suggest that the enhanced growth is caused by H₂O adsorption when the wafer is cooled down to room temperature:

Hf-O-Hf* + H₂O → 2 Hf-OH*

It has been shown that for moisture, concentrations as low as 10-100 ppm are sufficient for monolayer coverage of H₂O on HfO₂ at room temperature. Thus, the moisture background in the transport module could suffice for the introduction of -OH groups during the transport from ALD to nitride reactor and back. The adsorption of H₂O in the transport module saturates within 90 seconds: similar growth enhancement is achieved for 90 seconds or 5 minutes intermediate cooling.

Support for the H₂O reaction in the transport module comes from the observation that HfO₂ can be deposited without H₂O pulse in the ALD reactor at 300°C, but with intermediate cooling in the transport module instead (Table 2 reaction cycle 6 and 7). Probably, the Cl-content of this HfO₂ layer is very high, as the Cl removal becomes more difficult at lower temperatures. The expected high Cl-content might explain why the growth-per-cycle for this process is slightly lower than for the standard ALD process.

The growth-per-cycle is also enhanced for intermediate anneal at 420°C in the nitride reactor (table 2 reaction cycle 5), with the same amount as for intermediate cooling (table 2 reaction cycle 3 and 4). One would expect that the -OH density on the HfO₂ substrate decreases by thermal treatment, and as such, the growth-per-cycle is decreased. This probably indeed occurs during the intermediate anneal. However, the intermediate anneal is performed in the nitride reactor on the polygon platform, and the transport from nitride to ALD reactor takes about 2 minutes. As shown above, the HfO₂ surface can easily re-adsorb moisture during the cooling that occurs during this transport.

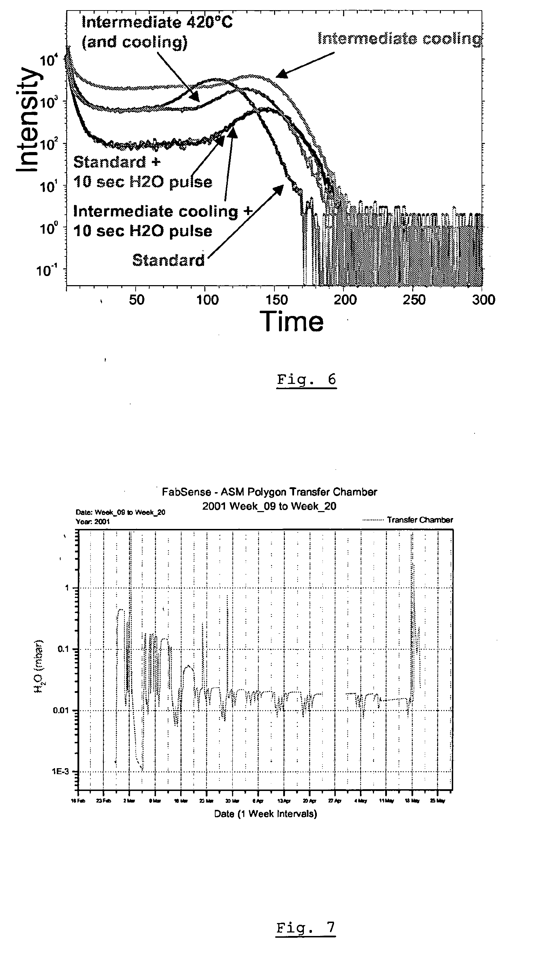

Analysis of the Cl content in HfO₂ layer can give more information on the ALD reaction mechanism because it shows the efficiency of Cl-removal by the H₂O reaction and/or the intermediate treatments applied after the H₂O reaction. TOFSIMS Cl-profiles of standard HfO₂ are therefore compared with HfO₂ deposited with the different extended reaction cycles (figure 5 and figure 6). The intermediate treatments are applied only every 10 reaction cycles instead of after every single reaction cycle in order to speed up the deposition of 4 nm HfO₂ layers (minimum thickness to obtain a reasonable Cl-profile). The effect of the intermediate treatment on the Cl content is still apparent in the Cl-profiles (figure 5 and figure 6).

One can see that HfO₂ deposited with plasma treatments or cooling in moisture contains about twice as much Cl as the Standard HfO₂ process (figure 5 and figure 6). Apparently, the standard H₂O pulse of 0.3 seconds is too short to hydrolyze the much larger amount of Hf-Cl bonds, introduced by the enhanced growth-per-cycle. Therefore, the H₂O pulse time is re-optimized for the enlarged growth-per-cycle. H₂O pulses of 10 seconds are sufficient to reduce the Cl-content too a similar level as for the process without intermediate cooling (Figure 6).

Cl can efficiently be removed by intermediate thermal treatments (figure 5 (a)). The temperature and frequency of the intermediate anneal determines the efficiency of the Cl-elimination. A reduction of 2 orders of magnitude is obtained with intermediate anneals at 500°C every 10 cycles. On the other hand, the Cl-content is not reduced during a post deposition anneal at 500°C (Figure 5 (b)). For intermediate thermal anneals at 420°C every 10 cycles, the Cl-content is reduced as compared to intermediate cooling, but the Cl-level is still at the same level as for the standard HfO₂ process. Applying a longer H₂O pulse gives in this case a larger improvement. The ambient of the intermediate anneal (O₂ or N₂) does not influence the Cl-content of the layers. However, it can have a significant impact on the thickness of the interfacial layer. For O₂ anneals at 500°C, the interfacial oxide easily grows to more than 1 nm.

The following HfCl₄/H₂O ALD reaction mechanism can be proposed.

Having regard to HfCl₄ reaction, in agreement with literature, it is proposed that HfCl₄ reacts with -OH groups and not with Hf-O-Hf bridges:

x OH* + HfCl₄ → OₓHfCl₄₋ₓ* + x HCl

All experimental observations in this work support that in the standard process, the amount of Hf deposited in this half reaction is controlled by the number of -OH groups on the substrate, and not by steric hindrance of the -Cl ligands.

This is further investigated by using a recent model of growth-per-cycle (Table 3). The model is based on the mass balance of chemisorption and assumes a two-dimensional arrangement of the adsorbed ligands.

For the standard HfO₂ process, the growth-per-cycle is 1.4 Hf/nm2 for plasma treatments [Table 2]. During the HfCl₄ reaction, each Hf atom brings along four Cl ligands (using the HfCl₄ precursor). Thus, according to mass balance, about 5.6 (= 4.1 x 4) Cl ligands /nm2 arrive to the surface. The maximum number of Cl ligands remaining on a flat surface when steric hindrance prevails can be estimated from the van der Waals radius of Cl (0.175 nm as 9.4 /nm2). Thus, for the standard process, the amount of Cl after HfCl₄ reaction is still lower than the maximum allowed by steric hindrance. However, the maximum amount of Cl is most likely slightly lower than this theoretical value because this upper limit does not consider the specific bond arrangements in the Hf-Cl layer. Thus for the standard process, the model cannot give much information about the OH group content of the substrate.

On the other hand, the model can give some information in case of growth enhancement with intermediate treatments. The growth-per-cycle is 4.1 Hf/nm2 for plasma treatments [Table 2]. Thus, according to mass balance, about 16.4 (= 4.1 x 4) Cl ligands /nm2 arrive to the surface. This is much higher than the maximum number of Cl ligands allowed on a flat surface (9 /nm2). Therefore, at least (16.6 - 9.4) ≈ 7 Cl /nm2 have been removed by reaction with -OH (Table 3). Thus, this number also is a rough estimation of the -OH group density on HfO₂ after plasma treatment. For intermediate cooling, the -OH group density calculated in a similar way is 2-3 /nm2 (Table 3).

**Table 3: Amount of -OH groups on HfO₂ for different intermediate treatments after the H₂O ALD half reaction obtained by using the steric hindrance model.**

| Description of the extended reaction cycle | # OH (/nm²) |
|---|---|
| Standard + RT plasma treatment | 7 |
| Standard + 5 min cooling | 3 |
| Standard + 90 sec cooling | 2 |
| Standard + 2 min 420°C + 2 min cooling | 2 |

Having regard to H₂O reaction, the HfCl bonds introduced during the HfCl₄ pulse are hydrolyzed in the H₂O reaction:

HfClₓ* + x H₂O → Hf(OH)ₓ* + x HCl

At 300°C, this reaction is not complete as some residual Cl is present in the HfO₂ layer even if the H₂O pulse is saturated.

As the temperature of the H₂O reaction decreases, dissociation of H₂O on oxygen bridges also becomes important:

Hf-O-Hf* + H₂O → 2 Hf-OH*

An effective way of eliminating Cl is by intermediate thermal annealing after the H₂O pulse. The Cl-content is independent of the anneal ambient (O₂ or N₂). It is proposed that neighboring Hf-Cl and Hf-OH groups at the top surface react and release HCl:

HfCl* + HfOH → HfOHf* + HCl

As such, oxygen bridges are created. It is proposed that this reaction becomes more important as the temperature of the anneal increases.

Thus, in order to enhance the growth-per-cycle from 15% to 40% of a monolayer and to reduce the Cl-content by 2 orders of magnitude, the following extended HfCl₄/H₂O ALD reaction cycle can be proposed:
- HfCl₄ reaction at 300°C
- H₂O reaction at 300°
- Annealing in N₂ for Cl-elimination at 500°C
- Hydroxylation with N₂O plasma during and/or after moisture exposure at low temperature.

The invention can also be described as follows in the next paragraphs (§116 to §195).

Atomic Layer Deposition (ALD) is a thin film deposition technique based on the use of separated chemisorption reactions of at least two gas phase reactants with a substrate.

There are two characteristics which may limit the quality and scalability of layers deposited by ALD.

A first characteristic is the growth-per-cycle (or growth rate), which often is much lower than the theoretical maximum of one monolayer per cycle. This can result in film roughness and slow film closure, which makes especially thin films (on the order of 0-5 nm) prone to localized defects such as pin holes.

A second characteristic is the presence of impurities due to unreacted precursor ligands.

In order to optimize the above characteristics, the present invention provides an ALD method for producing a high-quality layer comprising the steps of:
a) providing a semiconductor substrate in a reactor space
b) providing a pulse of a first precursor gas into the reactor space at a first temperature
c) providing a first pulse of a second precursor gas into the reactor space at a second temperature
d) providing a second pulse of the second precursor gas at a third temperature.
e) repeating step b) through step d)
and characterized in that the third temperature is lower than the second temperature.

The semiconductor substrate comprises silicon, germanium, silicon germanium or any semiconductor material suitable in the field of IC processing.

The high-quality layer is a layer selected from the group comprising substantially pure elements (e.g. Si, Cu, Ta, W), oxides (e.g. SiO₂, GeO₂, HfO₂, ZrO₂, Ta₂O₅, TiO₂, Al₂O₃, POₓ, VOₓ, CrOₓ, FeOₓ, ZnO, SnO₂, Sb₂O₅, B₂O₃, In₂O₃, WO₃), nitrides (e.g. Si₃N₄, TiN, TaNₓ, AIN, BN, GaN, NbN, MoₓN, W_{X}N), carbides (e.g. SiC), sulfides (e.g. CdS, ZnS, MnS, WS₂, PbS), selenides (e.g. CdSe, ZnSe), phosphides (e.g. GaP, InP), Arsenides (e.g. GaAs, InAs) and mixtures thereof.

The first precursor gas is selected from the group comprising metal halides and oxyhalides, being of the form MLx, MLxHy, MLxOy and the like, wherein M is a metal and L is an halogen. Examples are HfCl₄, TaCl₅, WF₆, WOCl₄, ZrCl₄, AlCl₃, POCl₃, etc.

The second precursor gas is selected from the group comprising H₂O, H₂O₂, O₂, O₃, NH₃, H₂S, H₂Se, PH₃, AsH₃, C₂H₄, Si₂H₆, or any second precursor able to eliminate the ligands of the first precursor.

In a method according to the invention the first temperature is between about 100 and about 800°C or between about 225 and about 375°C.

In a method according to the invention the second temperature is substantially equal or higher than the first temperature, between about 100 and about 800°C or between about 225 and about 375°C.

In a method according to the invention the third temperature is substantially lower than the second temperature, lower than about 225°C and preferably room temperature.

A method according to the invention further comprises the step of heating the substrate surface at a fourth temperature between step c) and d).

In a method according to the invention this fourth temperature is substantially equal or higher than the second temperature, higher than about 375°C and preferably equal to about 500°C.

In a method according to the invention, the step of heating the substrate surface at a fourth temperature is performed in inert atmosphere.

In a method according to the invention, the substrate is exposed to plasma during step d). The plasma can be direct or remote.

In a method according to the invention the plasma is selected from the group comprising N₂O, NO, O₂, N₂, H₂, NO₂, NH₃, etc.

In a method according to the invention the first and second temperature is about 300°C, the third temperature is room temperature and the fourth temperature is about 500°C.

A reactor design in which reactions are performed at their optimized temperature is the following:

An ALD reactor is proposed for producing a high-quality layer comprising:
- at least one reactor chamber,
- a first and a second susceptor,
- means for heating a substrate when present on the first susceptor,
- means for cooling the substrate when present on the second susceptor.

The ALD reactor may further comprise means for producing a plasma.

The means for heating may comprise flash lamps or any means to create a temperature increase of at least the substrate surface.

The means for cooling may comprise a recirculating cooling medium or a Peltier element or any means to create a temperature decrease of at least the substrate surface.

### Example:

As an example, for the deposition of hafnium oxide from hafnium tetrachloride and water the method according to the invention is as follows:
- providing a semiconductor substrate in the ALD reactor space,
- providing a pulse of HfCl₄ in the reactor space at 300°C,
- providing a first pulse of H₂O in the reactor space at 300°C,
- heating the substrate at 500°C in N₂ atmosphere,
- providing a second pulse of H₂O in the reactor space at room temperature. Optionally the substrate is exposed to N₂O plasma during this step.

The reaction cycle can then be repeated until the desired film thickness is obtained.

The first and second pulse of H₂O may comprise exposure to moisture in the reactor space.

Providing a pulse of HfCl₄, providing a first pulse of H₂O (which can comprise moisture exposure in this case) and heating the substrate may be performed at the first susceptor, which is maintained at a constant temperature of about 300°C. Heating means, e.g. (flash) lamps, are provided for fast wafer surface temperature increase from 300°C to 500°C when the substrate is present on the first susceptor.

Then the substrate is transported from the first to the second susceptor. The second H₂O pulse (which also can comprise moisture exposure during transportation in this case) and optionally plasma exposure may be performed on the second susceptor at lower temperature. Cooling means are provided for wafer surface temperature decrease below about 225°C or even to room temperature.

By means of conventional ALD, the deposition of hafnium oxide from hafnium tetrachloride and water, the growth-per-cycle is only 20 % of a monolayer and the Cl-impurities remain in the deposited layer.

By means of the method according to the invention, the growth-per-cycle may be enhanced from 15 to 40 % of a monolayer and the Cl-content may be reduced by 2 orders of magnitude.

### Experimental details:

Atomic Layer Deposition (ALD) is based on the use of separated chemisorption reactions of at least two gas phase reactants with a substrate.

For the deposition of HfO₂ from HfCl₄ and H₂O, HfCl₄, which is the first precursor, chemisorbs on the substrate by reaction with surface -OH groups:

x OH* + HfCl₄ → OₓHfCl₄₋ₓ* + x HCl (1)

The chemisorption must be self-limiting and saturated within the time of the precursor pulse. When full saturation is reached, the excess of HfCl₄ and the gas reaction byproducts are purged away by inert gas. Thereafter, pulse and purge steps are repeated with the H₂O precursor in order to hydrolyze the Hf-Cl bonds.

OₓHfCl₄₋ₓ* + (4-x) H₂O → OₓHf(OH)₄₋ₓ + (4-x) HCl (2)

This sequence is repeated until the desired HfO₂ film thickness is obtained.

Usually, the growth-per-cycle is less than 1 monolayer because of the following limitations: either the number of reactive sites on the substrate is limited, or steric effects from bulky precursors limit the amount of material to be chemisorbed.

Moreover, the growth-per-cycle can depend on the starting substrate - when the substrate changes from the starting substrate (for example silicon substrate) to the deposited material itself. When starting substrate effects have vanished, the growth-per-cycle becomes constant and is referred to as the steady growth-per-cycle.

Furthermore, the growth-per-cycle can depend on the temperature of the deposition.

For the HfCl₄/H₂O process, the steady growth-per-cycle at 300°C is only 15 - 17 % of a monolayer (%ML). Several experimental observations indicate that the low HfO₂ growth-per-cycle is caused by limitation of the number of reactive sites, the -OH groups in the HfCl₄ reaction.

For example, the decreasing growth-per-cycle as a function of temperature is attributed to decreased hydroxylation of the HfO₂ surface. This implies that the HfCl₄ reaction with oxygen bridging sites is not very efficient. Indeed, it has been shown that the ZrCl₄ species (the HfCl₄ and ZrCl₄ chemistries are very similar) are not very reactive towards siloxane bridges, since the preheating temperature of the support influences the amount of adsorbed Zr.

Furthermore, substrate inhibition occurs typically on surfaces with too low -OH density, for example HF cleaned Si.

Different intermediate treatments in the ALD reaction cycle, such as exposure to gas phase moisture, microwave plasma afterglow at low temperature or thermal anneals are studied.

In the case of intermediate plasma treatments, the extended process is referred to as Intermediate Remote Plasma Assisted (IRPA) ALD.

A first goal is to increase the number of -OH groups at the HfO₂ surface, in order to enhance the growth-per-cycle. A theoretical model predicts that the higher the growth-per-cycle, the lower the number of cycles required for film closure and the lower the roughness of the film. Therefore, the improvement of the quality and scalability of HfO₂ layers by enhancing the growth-per-cycle with intermediate treatments is investigated.

A second goal is to reduce the Cl-content of the HfO₂ layers. Indeed, the intermediate treatments can affect the growth-per-cycle and the Cl-content.

All samples are processed in a Polygon 8200 cluster. Prior to deposition, a chemical oxide of 1 nm thickness is grown HfO₂ is deposited in an ALCVD^{™} Pulsar^{®} 2000 reactor, a hot wall cross-flow type reactor with inert gas valving. The pressure in the reactor is 1.33 mbar (1 Torr). All depositions are performed at 300°C with HfCl₄ and H₂O precursors. HfCl₄ is a solid at room temperature. It is heated to approximately 185°C to achieve sufficient vapor pressure for the HfCl₄ pulses. The pulse and purge times for the standard process are indicated in Table 1. Elongation of the purge times after HfCl₄ or H₂O pulses up to 5 minutes does not change the growth-per-cycle, suggesting that the precursor pulses are well separated in the standard conditions. Moreover, this indicates that there is sufficient recovery time of the HfCl₄ solid source between different pulses. The saturation of the chemisorption reactions will be discussed bellow.

Intermediate treatments are performed in an Epsilon Nitride CVD (Chemical Vapor Deposition) reactor, equipped with a remote Microwave Radical Generator (MRG) or in the transport module of the polygon cluster. The base pressure and leak rate in the nitride reactor is 0.00799 mbar (6 mTorr) and 0.000266 mbar (0.2 mTorr) /minute respectively. The moisture level in the transport module of the polygon is monitored by a FabSense H₂O sensor (BOC Edwards) and is between 0.133 mbar (0.1 Torr) and 0.0133 mbar (0.01 Torr) (Figure 7).

Samples are measured by spectroscopic ellipsometry on a KLA-Tencor ASET F5. RBS is performed in a RBS400 end station (Charles Evans and Associates) with a 1 MeV He+ beam. TOFSIMS depth profiles are measured with an IonTOF-IV instrument using a dual beam set-up with a 500 eV Ar+ ion beam.

For standard HfCl₄/H₂O process at 300°C, the steady growth-per-cycle (as described in Table 1) is 1.4 Hf/nm² or 15% ML (Figure 2), in agreement with literature. The growth-per-cycle is not fully saturated with the standard H₂O pulse of 0.3 seconds, as shown in Figure 2. The growth-per-cycle saturates at a H₂O pulse of about 10 seconds to a value of 20 % ML. Also the Cl-content is saturated at 10 seconds, as shown by TOFSIMS (Figure 2). The growth-per-cycle does not depend on the HfCl₄ pulse length.

The effect of the 1 nm chemical oxide substrate on the growth-per-cycle is shown in Figure 3. In the first reaction cycle, the growth-per-cycle is almost 3 times higher than the steady growth-per-cycle (4.3 Hf/nm² or 47 %ML) in agreement with literature. The substrate enhancement only acts in the first reaction cycle. This is surprising, as the chemical oxide substrate can by no means be fully covered by HfO₂ in the first cycle, as less than half a ML is deposited. Therefore, one would expect to see growth enhancement also in the second reaction cycle.

One possible explanation is that all Si-OH groups on the chemical oxide are consumed by reaction with HfCl₄ in the first reaction cycle. Any Si-O-Si bridges left uncovered by HfO₂ are not hydrolyzed in the H₂O pulse of the first reaction cycle. Therefore, HfO₂ in the second reaction cycle only reacts with the Hf-OH groups and the steady HfO₂ growth-per-cycle is immediately reached. This would imply that, as the Si-O-Si sites are not reactive towards both HfCl₄ and H₂O precursors, no further growth is possible from the substrate; only sideward growth from HfO₂ islands is possible to cover that area.

Another possibility is that both Si-OH and Si-O-Si bridges react with HfCl₄. The reaction with the latter surface sites results in contamination of the Si substrate by Cl:

Si-O-Si* + HfCl₄ → Si-O-HfCl₃* + Si-Cl

Si-Cl bonds are difficult to hydrolyze at 300°C. Therefore, in the next reaction cycles, HfO₂ deposition on the Si-Cl sites is blocked. This would explain the larger Cl-content at the bottom interface of HfO₂ layers. The fact that the HfO₂ growth-per-cycle remains constant in the subsequent reaction cycles, and the decrease in Cl-content could indicate that nucleation on the HfO₂ substrate proceeds only on the Hf-OH groups, and that Hf-O-Hf bridges are less reactive than Si-O-Si bridges.

Intermediate plasma treatment every cycle enhance the steady growth-per-cycle from 15% ML to 42 % ML (Figure 3 and Table 4). The current estimation should be more accurate than previous estimations based on RBS results for intermediate plasma treatments every 10 cycles, which estimated the growth-per-cycle in the reaction cycle after the plasma treatment between 50-70 % ML.

A theoretical model for random deposition in ALD predicts that the higher the growth-per-cycle, the smaller the number of cycles required for film closure and the lower the roughness of the film. The growth mode of HfO₂ layers with different growth-per-cycle can be investigated by TOFSIMS surface measurements. The decay the Si substrate intensity is plotted as a function of the Hf-coverage from RBS (Figure 4).

Indeed, a faster decay of the TOFSIMS Si intensity for IRPA ALD HfO₂ as compared to standard HfO₂ (Figure 4). The difference with standard HfO₂ is small but systematic.

Table 4 summarizes the Growth-per-cycle (% ML) for different extended reaction cycles. The Hf-coverage is measured by RBS or SE on samples with 10 reaction cycles of ALD HfO₂. The growth-per-cycle is calculated as the average over the last 9 reaction cycles to exclude the enhancement effect of the substrate in the first reaction cycle.

**Table 4.**

| Description of the extended reaction cycle | GPC RBS (Hf/nm²) | GPC RBS (% ML) | GPC SE (% ML) |
|---|---|---|---|
| Standard | 1.40-1.50 | 15-16 % | 18-20 % |
| Standard + RT plasma treatment | 4.10 | 42 % | 49 % |
| Standard + 5 min cooling | 3.21 | 34 % | 40 % |
| Standard + 90 sec cooling | 2.89 | 32 % | 35 % |
| Standard + 2 min 420°C + 2 min cooling | 2.95 | 32 % | 35 % |
| HfCl₄ pulse + 4 min cooling | 0.85 | 9 % | 12 % |
| HfCl₄ pulse + 2 min 420C + 4 min cooling | 0.88 | 10 % | 11 % |
| 5 min pre-stabilization + standard | 2.77 | 30 % | 37 % |

The origin of the enhanced growth-per-cycle for intermediate plasma treatments is investigated.

Instability of the solid source: the intermediate plasma treatment results in a long waiting time between different HfCl₄ pulses. For the heated solid source, this longer recovery time could result in a higher HfCl₄ dose per pulse. In order to test this, the purge times after HfCl₄ or H₂O pulses are elongated up to 5 minutes (time of the intermediate treatments). This does not change the growth-per-cycle, suggesting that a constant amount of HfCl₄ is supplied per pulse even for long waiting times.

Impurity reduction: the remote plasma treatments, applied either as a post or intermediate treatment, can drive off residual precursor ligands such as Cl, H, resulting in purification and densification of the HfO₂ layer. It is expected that Cl impurities could be removed by hydrogen abstraction to form HCl. The N₂O plasma is a rich source of atomic oxygen and could eliminate residual H atoms in the HfO₂ layer or fill oxygen deficiencies. However, this hypothesis is not supported by TOFSIMS results, which indicate an increase rather than a decrease in Cl content (Figure 5) and no effect on H content.

Surface diffusion by the plasma treatment: plasma treatments can induce surface diffusion which can affect the surface morphology, roughness and islanding, of the growing HfO₂ layer. Different surface structures could allow a more efficient packing of the precursor on the HfO₂ top substrate.
Increased hydroxylation of the HfO₂ top surface: if the number of OH groups limits the growth-per-cycle, introducing more OH groups on the substrate can obviously increase it.

Dfg x OH* + HfCl₄ → OₓHfCl₄₋ₓ* + x HCl

In order to further investigate the two latter options, different intermediate treatments are considered after every reaction cycle, thus after the H₂O half reaction. The growth-per-cycle for different extended reaction cycles is summarized in table 4.

Growth enhancement is also observed for intermediate room temperature treatments without plasma. The growth-per-cycle (34 % ML) is slightly lower as compared to the remote plasma treatments (42 % ML). Thus, an important contribution of the growth enhancement during intermediate plasma treatments comes from lowering the temperature. Therefore, one could suggest that the enhanced growth is caused by H₂O adsorption when the wafer is cooled down to room temperature:

Hf-O-Hf* + H₂O → 2 Hf-OH*

It has been shown that for moisture concentrations as low as 10-100 ppm are sufficient for monolayer coverage of H₂O on HfO₂ at room temperature. Thus, the moisture background in the transport module could suffice for the introduction of -OH groups during the transport from ALD to nitride reactor and back. The adsorption of H₂O in the transport module saturates within 90 seconds: similar growth enhancement is achieved for 90 seconds or 5 minutes intermediate cooling.

Support for the H₂O reaction in the transport module comes from the observation that HfO₂ can be deposited without H₂O pulse in the ALD reactor at 300°C, but with intermediate cooling in the transport module instead (Table 4). Probably, the Cl-content of this HfO₂ layer is very high, as the Cl removal becomes more difficult at lower temperatures. The expected high Cl-content might explain why the growth-per-cycle for this process is slightly lower than for the standard ALD process.

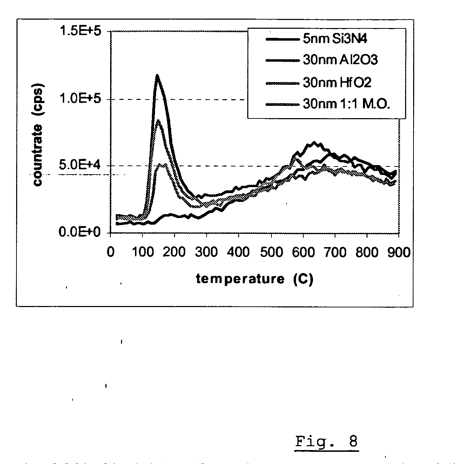

One concern with the extended reaction cycles is a possible CVD component in the ALD reaction by the introduction of physisorbed H₂O on the wafer during the loading of the wafer after each intermediate treatment. If the moisture level in the transport module is high enough, multilayers of H₂O can be physisorbed on the Hf02 surface. If physisorbed H₂O is not removed at 300°C before the beginning of the HfCl₄ pulse, it could react in the gas phase as in CVD. Standard, the wafer is stabilized for 30 seconds at 300°C in de ALD reactor before the first HfCl₄ pulse. The pre-stabilization time is elongated to 5 minutes in order to be sure that any physisorbed water is desorbed before the first HfCl₄ pulse. TDS indicates that all H₂O desorbs during heating from room temperature to 300°C in 5 minutes (Figure 8). Applying 5 minutes pre-stabilization also shows the growth-per-cycle enhancement, excluding the possibility of a CVD component in the ALD process.

The growth-per-cycle is also enhanced for intermediate anneal at 420°C in the nitride reactor, with the same amount as for intermediate cooling (Table 4). One would expect that the -OH density on the HfO₂ substrate decreases by thermal treatment, and as such, the growth-per-cycle is decreased. This probably indeed occurs during the intermediate anneal. However, the intermediate anneal is performed in the nitride reactor on the polygon platform, and the transport from nitride to ALD reactor takes about 2 minutes. As shown above, the HfO₂ surface can easily re-adsorb moisture during the cooling that occurs during this transport.

Analysis of the Cl content in HfO₂ layer can give more information on the ALD reaction mechanism because it shows the efficiency of Cl-removal by the H₂O reaction and/or the intermediate treatments applied after the H₂O reaction. TOFSIMS Cl-profiles of standard HfO₂ are therefore compared with HfO₂ deposited with the different extended reaction cycles (Figure 5, Figure 6). The intermediate treatments are applied only every 10 reaction cycles instead of after every single reaction cycle in order to speed up the deposition of 4 nm HfO₂ layers (minimum thickness to obtain a reasonable Cl-profile). The effect of the intermediate treatment on the Cl content is still apparent in the Cl-profiles (Figure 5 and Figure 6).

One can see that HfO₂ deposited with intermediate plasma treatments or cooling in moisture contains about twice as much Cl as the standard HfO₂ process (Figure 5 and Figure 6). Apparently, the standard H₂O pulse of 0.3 seconds is too short to hydrolyze the much larger amount of Hf-Cl bonds, introduced by the enhanced growth-per-cycle. Therefore, the H₂O pulse time is re-optimized for the enlarged growth-per-cycle. H₂O pulses of 10 seconds are sufficient to reduce the Cl-content too a similar level as for the process without intermediate cooling (Figure 6).

Cl can efficiently be removed by intermediate thermal treatments (Figure 5 (a)). The temperature and frequency of the intermediate anneal determines the efficiency of the Cl-elimination. A reduction of 2 orders of magnitude is obtained with intermediate anneals at 500°C every 10 cycles. On the other hand, the Cl-content is not reduced during a post deposition anneal at 500°C (Figure 5 (b)). For intermediate thermal anneals at 420°C every 10 cycles, the Cl-content is reduced as compared to intermediate cooling, but the Cl-level is still at the same level as for the standard HfO₂ process. Applying a longer H₂O pulse gives in this case a larger improvement. The ambient of the intermediate anneal (O₂ or N₂) does not influence the Cl-content of the layers. However, it can have a significant impact on the thickness of the interfacial layer. For O₂ anneals at 500°C, the interfacial oxide easily grows to more than 1 nm.

In agreement with literature, it is proposed that HfC14 reacts with -OH groups and not with Hf-O-Hf bridges:

x OH* + HfCl₄ → OₓHfCl₄₋ₓ* + x HCl

All experimental observations in this work support that in the standard process, the amount of Hf deposited in this half reaction is controlled by the number of -OH groups on the substrate, and not by steric hindrance of the -Cl ligands.

This is further investigated by using a recent model of growth-per-cycle (Table 3). The model is based on the mass balance of chemisorption and assumes a two-dimensional arrangement of the adsorbed ligands.

For the standard HfO₂ process, the growth-per-cycle is 1.4 Hf/nm² for intermediate plasma treatments [Table 4]. During the HfCl₄ reaction, each Hf atom brings along four Cl ligands (using the HfCl₄ precursor). Thus, according to mass balance, about 5.6 (= 4.1 x 4) Cl ligands/nm² arrive to the surface. The maximum number of Cl ligands remaining on a flat surface when steric hindrance prevails can be estimated from the van der Waals radius of Cl (0.175 nm as 9.4 /nm²). Thus, for the standard process, the amount of Cl after HfCl₄ reaction is still lower than the maximum allowed by steric hindrance. However, the maximum amount of Cl is most likely slightly lower than this theoretical value because this upper limit does not consider the specific bond arrangements in the Hf-Cl layer. Thus for the standard process, the model cannot give much information about the OH group content of the substrate.

On the other hand, the model can give some information in case of growth enhancement with intermediate treatments. The growth-per-cycle is 4.1 Hf/nm² for intermediate plasma treatments [Table 4]. Thus, according to mass balance, about 16.4 (= 4.1 x 4) Cl ligands /nm² arrive to the surface. This is much higher than the maximum number of Cl ligands allowed on a flat surface (9/nm²). Therefore, at least (16.6 - 9.4) ≈ 7 Cl /nm² have been removed by reaction with -OH (Table 3). Thus, this number also is a rough estimation of the -OH group density on HfO₂ after intermediate plasma treatment. For intermediate cooling, the -OH group density calculated in a similar way is 2-3 /nm² (Table 3).

The HfCl bonds introduced during the HfCl₄ pulse are hydrolyzed in the H₂O reaction:

HfClₓ* + x H₂O → Hf(OH)ₓ* + x HCl

At 300°C, this reaction is not complete as some residual Cl is present in the HfO₂ layer even if the H₂O pulse is saturated.

As the temperature of the H₂O reaction decreases, dissociation of H₂O on oxygen bridges also becomes important:

Hf-O-Hf* + H₂O → 2 Hf-OH*

An effective way of eliminating Cl is by intermediate thermal annealing after the H₂O pulse. The Cl-content is independent of the anneal ambient (O₂ or N₂). It is proposed that neighboring Hf-Cl and Hf-OH groups at the top surface react and release HCl:

HfCl* + HfOH → HfOHf* + HCl

As such, oxygen bridges are created. It is propose that this reaction becomes more important as the temperature of the anneal increases.

The reaction cycle with intermediate thermal anneals enhances of the growth-per-cycle from 15 to 40 % of a monolayer and reduces the Cl-content by 2 orders of magnitude:
- HfCl₄ reaction at 300°C
- H₂O reaction at 300°C
- Annealing in N₂ for Cl-elimination at 500°C
- Hydroxylation with N₂O plasma or moisture exposure at low temperature in order to achieve saturation of the number of -OH groups

## Claims

1. An Atomic Layer Deposition method comprising the steps of:
a) providing a semiconductor substrate in a reactor,
b) providing a pulse of a first precursor gas into the reactor at a first temperature,
c) providing a first pulse of a second precursor gas into the reactor at a second temperature,
d) providing a second purse of the second precursor gas at a third temperature lower than the second temperature, and
e) optionally, repeating at least once step b) through step d) till a desired layer thickness is achieved.

2. A method according to claim 1, wherein the semiconductor substrate comprises any semiconductor material suitable in the field of IC processing.

3. A method according to claim 2, wherein said semiconductor substrate comprises silicon, germanium or silicon germanium.

4. A method according to any of claims 1 to 3, wherein said first precursor gas is a halide or an oxyhalide.

5. A method according to claim 4, wherein said halide is a metal halide or said oxyhalide is a metal oxhyhalide.

6. A method according to claim 4 or 5 wherein said first precursor gas is HfCl₄, TaCl₅, WF₆, WOCl₄, ZrCl₄, AlCl₃, POCl₃, TiCl₄, or SiCl₄.

7. A method according to any of claims 1 to 6, wherein said second precursor gas is any precursor able to eliminate the ligands of the first precursor.

8. A method according to claim 7 wherein said second precursor gas consists of H₂O, H₂O₂, O₂, O₃, NH₃, H₂S, H₂Se, PH₃, AsH₃, C₂H₄ or Si₂H₆.

9. A method according to any of claims 1 to 8, wherein said first temperature is comprised between 100°C. and 800°C.

10. A method according to any of claims 1 to 9, wherein said second temperature is substantially equal or higher than said first temperature.

11. A method according to any of claims 1 to 10 further comprising the step of heating the substrate surface at a fourth temperature, between step c) and d).

12. A method according to claim 11, wherein said fourth temperature is substantially equal or higher than the second temperature.

13. A method according to claim 11 or 12, wherein the step of heating the substrate surface at a fourth temperature is performed in inert atmosphere.

14. A method according to any of claims 1 to 13, wherein said first temperature and said second temperature are 304°C, and said third temperature is room temperature.

15. A method according to claim 14 wherein, said fourth temperature is 500°C.

16. A method according to any of claims 1 to 15, wherein said substrate is exposed to a plasma treatment during and/or after step d).

17. A method according to claim 16, wherein said plasma consists of N₂O, NO, O₂, N₂, H₂, NO₂ or NH₃.

18. A method according to any of claims 1 to 17, wherein said first precursor gas is hafnium tetrachloride and said second precursor gas is H₂O.

19. A method according to claim 18, wherein the substrate is exposed to an N₂O plasma treatment during and/or after step d).

## Patentansprüche

1. Atomschicht-Abscheidungsverfahren, umfassend folgende Schritte:
a) Bereitstellen eines Halbleitersubstrats in einem Reaktor,
b) Bereitstellen eines Impulses eines ersten Vorläufergases in den Reaktor auf einer ersten Temperatur,
c) Bereitstellen eines ersten Impulses eines zweiten Vorläufergases in den Reaktor auf einer zweiten Temperatur,
d) Bereitstellen eines zweiten Impulses des zweiten Vorläufergases auf einer dritten Temperatur, die niedriger ist als die zweite Temperatur, und
e) wahlweise, mindestens einmaliges Wiederholen der Schritte b) bis d), bis eine erwünschte Schichtdicke erreicht ist.

2. Verfahren nach Anspruch 1, wobei das Halbleitersubstrat ein beliebiges Halbleitermaterial umfasst, das für den Bereich der Behandlung von integrierten Schaltkreisen geeignet ist.

3. Verfahren nach Anspruch 2, wobei das Halbleitersubstrat Silizium, Germanium oder Silizium-Germanium umfasst.

4. Verfahren nach einem der Ansprüche 1 bis 3, wobei das erste Vorläufergas ein Halogenid oder ein Oxyhalogenid ist.

5. Verfahren nach Anspruch 4, wobei das Halogenid ein Metall-Halogenid oder das Oxyhalogenid ein Metall-Oxyhalogenid ist.

6. Verfahren nach Anspruch 4 oder 5, wobei das erste Vorläufergas HfCl₄, TaCl₅, WF₆, WOCl₄, ZrCl₄, AlCl₃, POCl₃, TiCl₄ oder SiCl₄ ist.

7. Verfahren nach einem der Ansprüche 1 bis 6, wobei das zweite Vorläufergas ein beliebiger Vorläufer ist, der in der Lage ist, die Liganden des ersten Vorläufers abzuspalten.

8. Verfahren nach Anspruch 7, wobei das zweite Vorläufergas aus H₂O, H₂O₂, O₂, O₃, NH₃, H₂S, H₂Se, PH₃, AsH₃, C₂H₄ oder Si₂H₆ besteht.

9. Verfahren nach einem der Ansprüche 1 bis 8, wobei die erste Temperatur zwischen 100 °C und 800°C liegt.

10. Verfahren nach einem der Ansprüche 1 bis 9, wobei die zweite Temperatur im Wesentlichen gleich oder höher ist als die erste Temperatur.

11. Verfahren nach einem der Ansprüche 1 bis 10, ferner umfassend den Schritt des Erwärmens der Substratoberfläche auf eine vierte Temperatur, zwischen den Schritten c) und d).

12. Verfahren nach Anspruch 11, wobei die vierte Temperatur im Wesentlichen gleich oder höher ist als die zweite Temperatur.

13. Verfahren nach Anspruch 11 oder 12, wobei der Schritt des Erwärmens der Substratoberfläche auf eine vierte Temperatur in einer Schutzgashülle ausgeführt wird.

14. Verfahren nach einem der Ansprüche 1 bis 13, wobei die erste Temperatur und die zweite Temperatur 300°C betragen und die dritte Temperatur Raumtemperatur ist.

15. Verfahren nach Anspruch 14, wobei die vierte Temperatur 500°C beträgt.

16. Verfahren nach einem der Ansprüche 1 bis 15, wobei das Substrat einer Plasmabehandlung während und/oder nach Schritt d) ausgesetzt wird.

17. Verfahren nach Anspruch 16, wobei das Plasma aus N₂O, NO, O₂, N₂, H₂, NO₂ oder NH₃ besteht.

18. Verfahren nach einem der Ansprüche 1 bis 17, wobei das erste Vorläufergas Hafniumtetrachlorid und das zweite Vorläufergas H₂O ist.

19. Verfahren nach Anspruch 18, wobei das Substrat einer N₂O-Plasmabehandlung während und/oder nach Schritt d) ausgesetzt wird.

## Revendications

1. Procédé de dépôt de couche atomique, comprenant les étapes consistant à :
a) fournir un substrat semi-conducteur dans un réacteur,
b) fournir une impulsion d'un premier gaz précurseur dans le réacteur à une première température,
c) fournir une première impulsion d'un deuxième gaz précurseur dans le réacteur à une deuxième température,
d) fournir une deuxième impulsion du deuxième gaz précurseur à une troisième température inférieure à la deuxième température, et
e) en option, répéter au moins une fois les étapes b) à d) jusqu'à ce qu'une épaisseur de couche souhaitée soit atteinte.

2. Procédé selon la revendication 1, dans lequel le substrat semi-conducteur comprend un matériau semi-conducteur approprié quelconque dans le domaine du traitement des circuits intégrés.

3. Procédé selon la revendication 2, dans lequel ledit substrat semi-conducteur comprend du silicium, du germanium ou du silicium-germanium.

4. Procédé selon l'une quelconque des revendications 1 à 3, dans lequel ledit premier gaz précurseur est un halogénure ou un oxyhalogénure.

5. Procédé selon la revendication 4, dans lequel ledit halogénure est un halogénure de métal ou ledit oxyhalogénure est un oxyhalogénure de métal.

6. Procédé selon la revendication 4 ou 5, dans lequel ledit premier gaz précurseur est du HfCl₄, TaCl₅, WF₆, WOCl₄, ZrCl₄, AlCl₃, POCl₃, TiCl₄ ou SiCl₄.

7. Procédé selon l'une quelconque des revendications 1 à 6, dans lequel ledit deuxième gaz précurseur est un précurseur quelconque capable d'éliminer les ligands du premier précurseur.

8. Procédé selon la revendication 7, dans lequel ledit deuxième gaz précurseur se compose de H₂O, H₂O₂, O₂, O₃, NH₃, H₂S, H₂Se, PH₃, AsH₃, C₂H₄ ou Si₂H₆.

9. Procédé selon l'une quelconque des revendications 1 à 8, dans lequel ladite première température est comprise entre 100°C et 800 °C.

10. Procédé selon l'une quelconque des revendications 1 à 9, dans lequel ladite deuxième température est substantiellement égale ou supérieure à ladite première température.

11. Procédé selon l'une quelconque des revendications 1 à 10, comprenant en outre l'étape consistant à chauffer la surface de substrat à une quatrième température, entre les étapes c) et d).

12. Procédé selon la revendication 11, dans lequel ladite quatrième température est substantiellement égale ou supérieure à la deuxième température.

13. Procédé selon la revendication 11 ou 12, dans lequel l'étape consistant à chauffer la surface de substrat à une quatrième température est effectuée dans une atmosphère inerte.

14. Procédé selon l'une quelconque des revendications 1 à 13, dans lequel ladite première température et ladite deuxième température sont de 300°C et ladite troisième température est une température ambiante.

15. Procédé selon la revendication 14, dans lequel ladite quatrième température est de 500 °C.

16. Procédé selon l'une quelconque des revendications 1 à 15, dans lequel ledit substrat est exposé à un traitement au plasma pendant et/ou après l'étape d).

17. Procédé selon la revendication 16, dans lequel ledit plasma se compose de N₂O, NO, O₂, N₂, H₂, NO₂ ou NH₃.

18. Procédé selon l'une quelconque des revendications 1 à 17, dans lequel ledit premier gaz précurseur est du tétrachlorure d'hafnium et ledit deuxième gaz précurseur est du H₂O.

19. Procédé selon la revendication 18, dans lequel le substrat est exposé à un traitement au plasma de N₂O pendant et/ou après l'étape d).
